# EUROPEAN PATENT APPLICATION

(11) **EP 1 380 880 A1**
(43) Date of publication of application: **14.01.2004**
(21) Application number: 03010222.2
(22) Date of filing: 10.12.1996
(51) Int. Cl.: G02F 1/1362

(54) **Method for manufacturing liquid crystal display**

(30) Priority: 28.12.1995 KR 9562170; 29.05.1996 KR 9618516
(62) Divisional of application: 96308925.5
(71) Applicant: SAMSUNG ELECTRONICS CO., LTD., Suwon-City, Kyungki-do (KR)
(72) Inventor: Kweon, Young-Chan, Youngdeungpo-gu, Seoul (KR)
(74) Representative: Greene, Simon Kenneth

(57) **Abstract**

A method for manufacturing a liquid crystal display which reduces the number of photolithography processes is provided. The method includes the steps of forming a gate electrode (31,33) and a gate pad (31) by depositing a first metal film and a second metal film on a substrate of a TFT area and a gate-pad connecting area, respectively, in the described order, by a first photolithography process, forming an insulating film (35) on the entire surface of the substrate on which the gate electrode and the gate pad are formed, forming a semiconductor film pattern on the insulating film of the TFT area by a second photolithography process, forming a source electrode/drain electrode and pad electrode composed of a third metal film (41) using a third photolithography process in the TFT portion and pad portion, respectively, forming a passivation film pattern (43) which exposes a portion of the drain electrode, a portion of the gate pad, and a portion of the pad electrode by a fourth photolithography process, exposing the first metal film by etching the second metal film which constitutes the gate pad using the passivation film pattern as a mask, and forming a pixel electrode (47) connected to the drain electrode of the TFT area for connecting the gate pad of the gate-pad connecting area to the pad electrode of the pad area using a fifth photolithography process. Therefore, it is possible to reduce the number of photolithography processes, to improve the manufacturing yield, and to supress growth of a hillock of an Al film.

## Description

### Background of the Invention

The present invention relates to a method for manufacturing a liquid crystal display, and more particularly, to a method for manufacturing a liquid crystal display having a thin film transistor as an active device, by which it is possible to reduce the number of the photolithography processes.

The liquid crystal display LCD is currently the most widely used flat-panel display device. Other devices being developed and rapidly becoming popularized include the plasma display panel (PDP), the electro luminescence (EL) device, the field emission display (FED), and a reflex deformable mirror device (DMD) which controls the movement of a mirror.

The LCD uses an optical characteristic of liquid crystal molecules in which the arrangement thereof changes according to an electrical field and a semiconductor technology which forms minute patterns. A thin film transistor LCD (hereinafter referred to as TFT-LCD) which uses the thin film transistor as the active device has the advantages of being driven at a low voltage, has low power consumption, thin and lightweight.

Since the thin film transistor (TFT) is far thinner than a general transistor, the manufacturing process thereof is more complicated than that of the general transistor, thus production is time-consuming and costs are high. In particular, since a mask is used in every manufacturing step, at least seven masks are required. Therefore, various methods for increasing the productivity of the TFT and lowering the manufacturing costs are being studied. That is, much research is being conducted on methods for reducing the number of the masks used during the manufacturing process of the TFT.

One method for manufacturing the LCD according to a conventional method is described in U.S. Patent No. 5,054,887. The method will be described with reference, FIGS. 1 to 5 showing sectional views in which sections A and B denote a TFT area and a gate-pad connecting area, respectively.

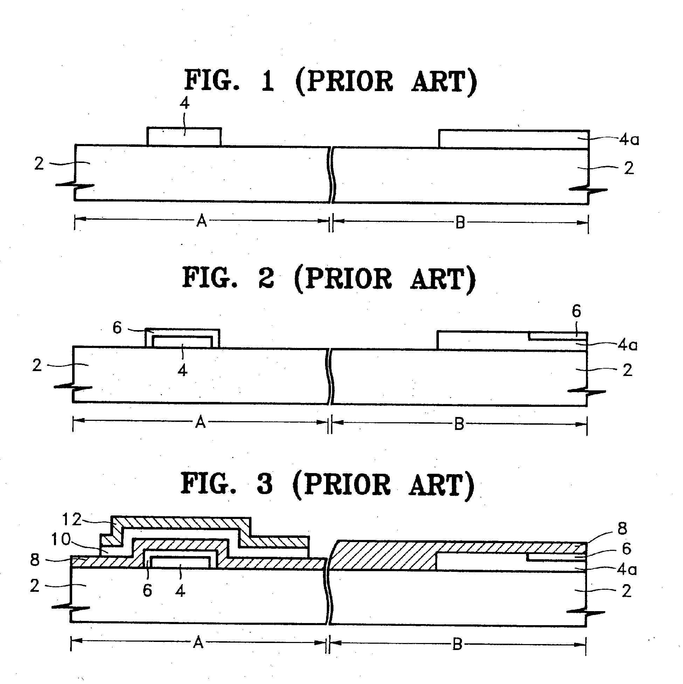

Referring to FIG. 1, after forming a first metal film using pure Al on a transparent substrate 2, gate patterns 4 and 4a are formed by performing a first photolithography on the first metal film. The gate patterns are used as a gate electrode 4 in the TFT area and as a gate pad 4a in the gate-pad connecting area.

Referring to FIG. 2, after forming a photoresist pattern (not shown) which covers a portion of the gate-pad connecting area by performing a general photolithography, an anodized film 6 is formed by oxidizing the first metal film using the photoresist pattern as an anti-oxidation film. At this time, the anodized film 6 is formed on the entire surface of the gate electrode 4 formed in the TFT area and on a portion of the gate pad 4a which is located in the gate-pad connecting area.

Referring to FIG. 3, an insulating film 8 is formed by depositing, for example, a nitride film on the entire surface of the substrate 2 having the anodized film. Then, a silicon film is formed by successively depositing an amorphous silicon film 10 and a doped amorphous silicon film 12 on the entire surface of the substrate 2 on which the insulating film 8 is formed, a semiconductor film pattern 10+12 to be used as an active region is formed in the TFT area by performing a third photolithography on the semiconductor film.

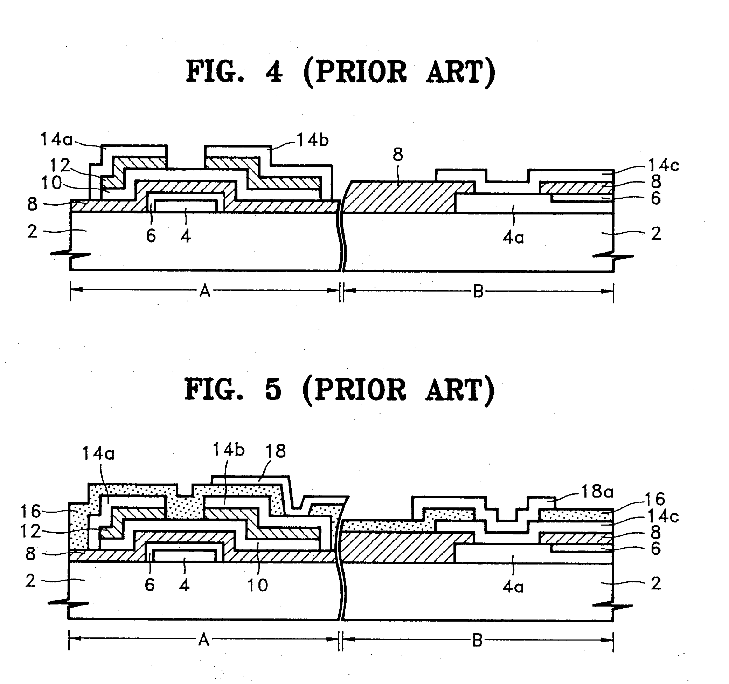

Referring to FIG. 4, a photoresist pattern (not shown) is formed exposing a portion of the gate pad 4a formed in the gate-pad connecting area by performing a fourth photolithography on the entire surface of the substrate 2 on which the semiconductor film pattern is formed. Then, a contact hole which exposes some portion of the gate pad 4a is formed by etching the insulating film 8 using the photoresist pattern as a mask. Then, a source electrode 14a and a drain electrode 14b are formed in the TFT area by depositing, for example, Cr on the entire surface of the substrate on which the contact hole is formed and performing a fifth photolithography on the Cr film. In the gate-pad connecting area, a pad electrode 14c connected to the gate pad 4a is formed through the contact hole. At this time, a portion of the doped amorphous silicon film 12 is etched, thus exposing a portion of the amorphous silicon film 10 on the upper portion of the gate electrode.

Referring to FIG. 5, a passivation film 16 is formed by depositing, for example, an oxide film, on the entire surface of the substrate 2 in which the source electrode 14a, the drain electrode 14b and the pad electrode 14c are formed. Then, the contact hole which exposes a portion of the drain electrode 14b of the TFT area and a portion of the pad electrode 14c of the gate-pad connecting area is formed by performing a sixth photolithography on the passivation film.

Then, pixel electrodes 18 and 18a are formed by depositing indium tin oxide ITO which is a transparent conductive material on the entire surface of the substrate on which the contact hole is formed and performing a seventh photolithography on the ITO film. As a result, the drain electrode 14b and the pixel electrode 18 are connected in the TFT area and the pad electrode 14c and the pixel electrode 18a are connected in the gate-pad connecting area.

According to the conventional method for manufacturing the LCD, pure Al is used as the gate electrode material for lowering the resistance of a gate line. Therefore, an anodizing process is required to prevent a hillock caused by the Al, thus complicating the manufacturing process, reducing the productivity, and increasing the manufacturing costs.

### Summary of the Invention

It is an object of the present invention to provide a more efficient method for manufacturing a liquid crystal display in which manufacturing costs are reduced by reducing the number of photolithography processes.

To achieve the above object, there is provided a method for manufacturing a liquid crystal display according to the present invention, comprising the steps of forming a gate electrode and a gate pad by depositing a first metal film and a second metal film on a substrate of a TFT area and a gate-pad connecting area, respectively, in the described order, by a first photolithography process, forming an insulating film on the entire surface of the substrate on which the gate electrode and the gate pad are formed, forming a semiconductor film pattern on the insulating film of the TFT area by a second photolithography process, forming a source electrode/drain electrode and pad electrode composed of a third metal film using a third photolithography process in the TFT portion and pad portion, respectively, forming a passivation film pattern which exposes a portion of the drain electrode, a portion of the gate pad, and a portion of the pad electrode by a fourth photolithography process, exposing the first metal film by etching the second metal film which constitutes the gate pad using the passivation film pattern as a mask, and forming a pixel electrode connected to the drain electrode of the TFT area for connecting the gate pad of the gate-pad connecting area to the pad electrode of the pad area using a fifth photolithography process.

The first metal film is formed of a refractory metal, i.e., one selected from the group consisting of Cr, Ta, Mo, and Ti and the second metal film is formed of Al or an Al alloy.

The third metal film is formed of one selected from the group consisting of Cr, Ta, Mo, and Ti.

Taper etching is performed on the second metal film in the first photolithography process and then etching the first metal film is performed, thus the first metal film is formed wider than the second metal film.

To achieve the above object, there is provided another method for manufacturing a liquid crystal display, comprising the steps of forming a gate electrode and a gate pad by depositing a first metal film and a second metal film on a substrate of a TFT area and a pad area, respectively, in the order described, by a first photolithography process, forming an insulating film on the entire surface of the substrate on which the gate electrode and the gate pad are formed, forming a semiconductor film pattern on the insulating film of the TFT area by a second photolithography process, forming a source electrode and a drain electrode composed of a third metal film in the TFT area by a third photolithography process, forming a passivation film pattern which exposes a portion of the drain electrode of the TFT area and a portion of the gate pad of the pad area by forming a passivation film on the entire surface on which the source electrode and the drain electrode are formed and performing a fourth photolithography process on the passivation film and the insulating film, exposing the first metal film of the pad area by etching the second metal film using the passivation film pattern as a mask, and forming a pixel electrode which is connected to the drain electrode of the TFT area and contacts the first metal film of the pad area by a fifth photolithography process.

The first metal film is formed of a refractory metal, i.e., one selected from the group consisting of Cr, Ta, Mo, and Ti and the second metal film is formed of Al or an Al alloy.

The third metal film is formed of one selected from the group consisting of Cr, Ta, Mo, and Ti and the insulating film is formed of a nitride film SiNₓ or a double film of a nitride film SiNₓ and an oxide film SiOₓ.

Taper etching is performed on the second metal film in the first photolithography process and then etching the first metal film is performed.

According to the present invention, it is possible to reduce the number of photolithography processes by forming the gate electrode in a double structure of a refractory metal film and an Al film formed on the upper portion of the refractory metal film, thus sharply reducing manufacturing costs and improving manufacturing yield. Also, it is possible to suppress growth of a hillock of the Al film due to a stress relaxation of the refractory metal film and to reduce contact resistance between a pixel electrode to be formed in a following process and the Al film by etching the Al film which constitutes the gate electrode prior to forming the pixel electrode.

### Brief Description of the Drawings

The above object and advantages of the present invention will become more apparent by describing in detail a preferred embodiment thereof with reference to the attached drawings in which:
FIGS. 1 through 5 are sectional views for explaining the method for manufacturing a liquid crystal display according to a conventional method;
FIG. 6 is a schematic plan view illustrating the mask patterns used in manufacturing a liquid crystal display according to the method of the present invention;
FIGS. 7 through 12 are sectional views for explaining a method for manufacturing a liquid crystal display according to a first embodiment of the present invention; and
FIGS. 13 through 16 are sectional views for explaining a method for manufacturing a liquid crystal display according to a second embodiment of the present invention.

### Detailed Description of the Invention

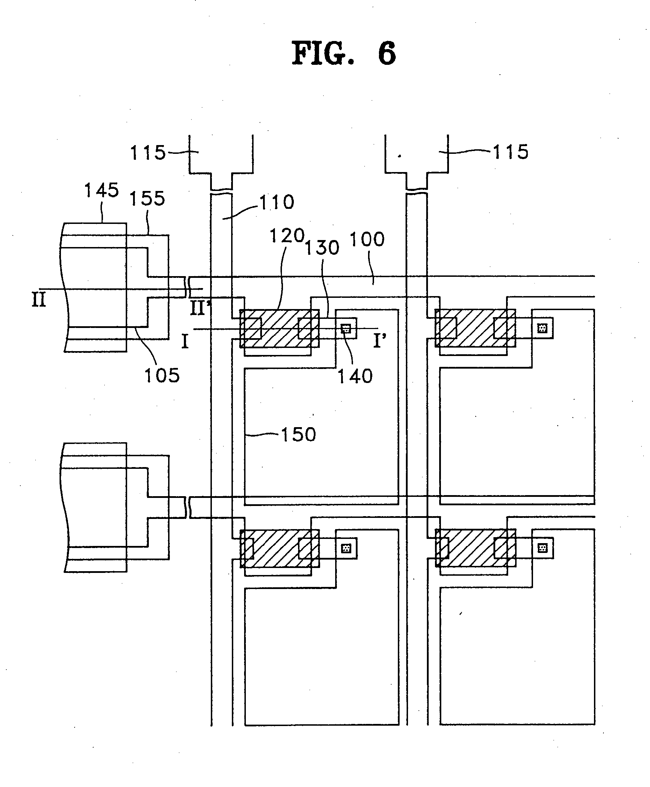

FIG. 6 is a schematic plan view illustrating the mask patterns used in manufacturing a liquid crystal display according to the method of the present invention, in which reference numeral 100 demotes a mask pattern for forming a gateline, reference numeral 105 denotes a mask pattern for forming a gate pad, reference numeral 110 denotes a mask pattern for forming a data line, reference numeral 120 denotes a mask pattern for forming a semiconductor film, reference numeral 130 denotes a mask pattern for forming a source electrode/drain electrode, reference numeral 140 denotes a mask pattern for forming a contact hole for connecting a pixel electrode of a TFT area to the drain electrode of the TFT area, reference numeral 145 denotes a mask pattern for forming a gate and of a gate pad connecting portion, reference numeral 150 denotes a mask pattern for forming the pixel electrode of the TFT area, and reference numeral 155 denotes a mask pattern for forming the pixel electrode of the gate-pad connecting area.

Referring to FIG. 6, the gate line 100 is horizontally arranged, the data line 110 is horizontally arranged, the data line 110 is arranged in a matrix pattern perpendicular to the gate line 100, the gate pad 105 is provided at the end portion of the gate line 100, and the data pad 115 is provided at the end portion of the data line 110. Pixel regions are respectively arranged in the matrix pattern in the region bounded by the two gate lines adjacent to each other and the data line. The gate electrodes of the respective TFTs are formed so as to extent to the pixel regions from the respective gate lines. The semiconductor film 120 is formed between the drain electrodes of the respective TFTs and the gate electrodes of the respective TFTs. The source electrodes of the TFTs are formed to protrude. The pixel electrodes 150 composed of the transparent ITO are formed in the respective pixel regions.

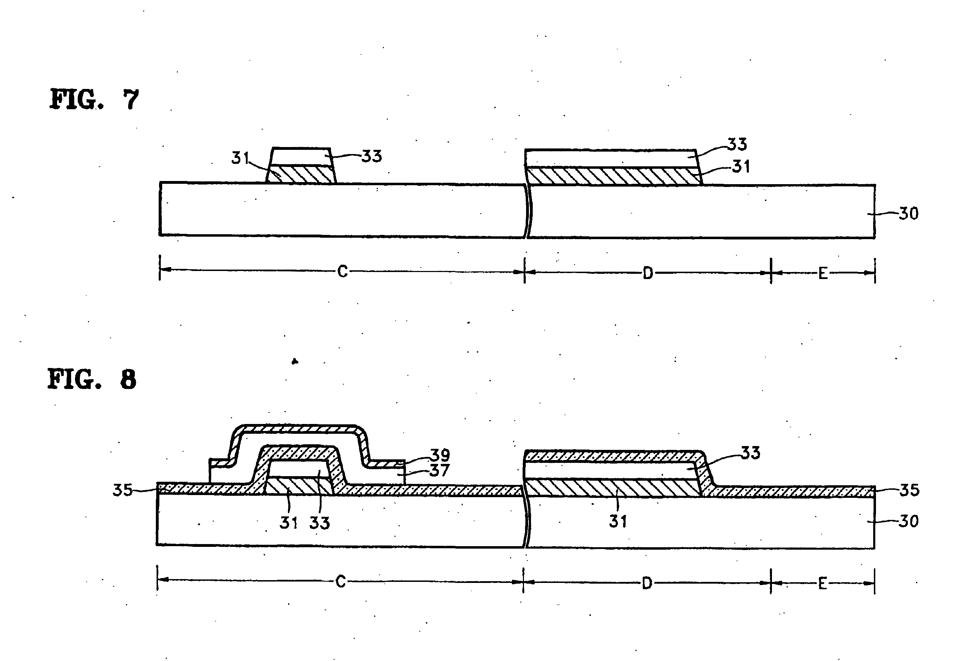

FIGS. 7 to 12 are sectional views for explaining a method for manufacturing a liquid crystal display according to a first embodiment of the present invention. The reference character C denotes the TFT area, which is a sectional view taken along I-I' of FIG. 6. The reference characters D and E denote the gate-pad connecting area and the pad area, which is a sectional view taken along II-II' of FIG. 6.

FIG. 7 shows the steps for forming a gate electrode. After forming a first metal film 31 by depositing a 300Å-4,000Å thick film of refractory metal from the group consisting of Cr, Ta, Mo, and Ti,(preferably Cr)on a transparent substrate 30, a second metal film 33 is formed by depositing a 1,000Å-4,000Å thick film of Al or an Al alloy on the first metal film 31. Here, the second metal film 33 can also be formed of Al-Nd or Al-Ta. Then, gate electrodes are formed in the TFT area and the gate-pad connecting area by performing a first photolithography on the first and the second metal films 31 and 33. At this time, the first photolithography process is performed by taper-etching the second metal film 33 and then the first metal film 31. Thus, the width of the first metal film 31 is formed to be larger than that of the second metal film 33.

It is possible to prevent generation of an Al hillock caused by the differences in thermal expansion between the Al film or the Al alloy film and the substrate by forming a refractory metal film in the lower portion of the Al film or the Al alloy film. Also, it is possible to perform the taper etching using the difference in etching ratio between the Al film or the Al alloy film and the substrate even though a conventional etching processing is applied. Therefore, a step coverage is preferably performed when depositing a following material after forming the gate electrode.

FIG. 8 shows the steps for forming a semiconductor film pattern. An insulating film 35 is formed by depositing a nitride film or an oxide film, for example, on the entire surface of the substrate 30 on which the gate electrode is formed. Then, a semiconductor film is formed by depositing an amorphous silicon film 37 and a doped amorphous silicon film 39 on the entire surface of the substrate 30 on which the insulating layer is formed. Then, a semiconductor film pattern composed of the amorphous silicon film 37 and the doped amorphous silicon film 39 is formed in the TFT area by performing a second photolithography on the semiconductor film. The insulating film 35, the amorphous silicon film 37 and the doped amorphous silicon film 39 are respectively formed to thicknesses of 2,000^{∼}9,000Å, 1,000^{∼}4,000Å, and 300^{~}1,000Å.

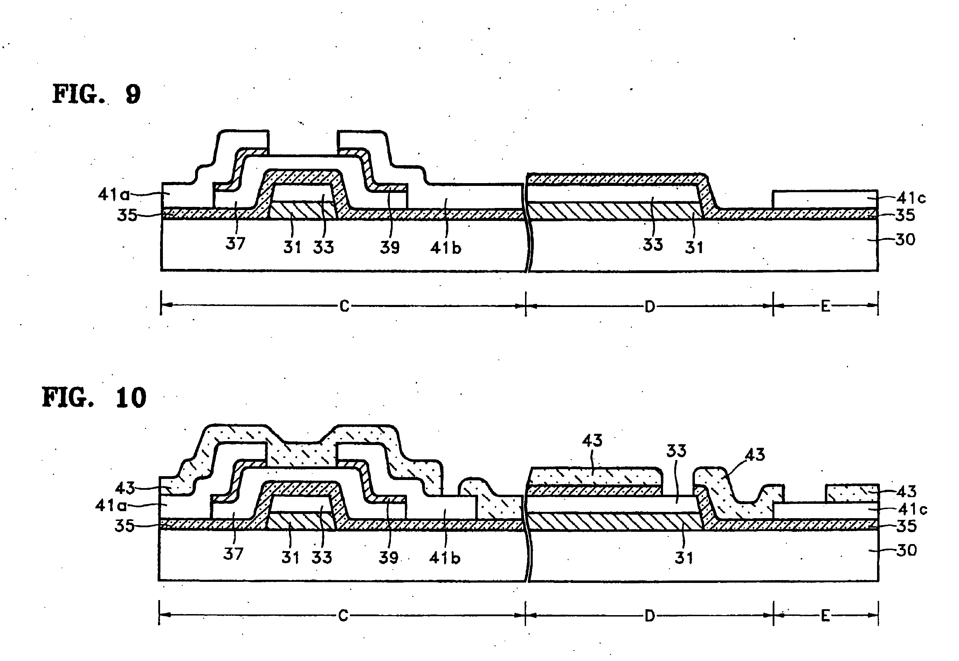

FIG. 9 shows the steps for forming a source electrode and a drain electrode. After forming a third metal film by depositing 300^{~}4,000Å thick film of a refractory metal such as the Cr on the entire surface of the substrate on which the semiconductor film pattern is formed, a source electrode 41a and a drain electrode 41b are formed in the TFT area by performing a third photolithography on the third metal film and a pad electrode 41c is formed in the pad area. At this time, a portion of the doped amorphous silicon film 39 is etched, thus exposing a portion of the amorphous silicon film 37.

FIG. 10 shows the steps for forming a passivation film pattern. After forming a passivation film using, for example, a nitride film on the entire surface of the substrate 30, a passivation film pattern 43 is formed by performing a fourth photolithography on the passivation film. At this time, a portion of the drain electrode 41b of the TFT area and a portion of the pad electrode 41c of the pad area are exposed. The gate electrode formed in the gate pad connecting portion, namely, the passivation film pattern 43 and the insulating film 35 formed on the second metal film 33 are simultaneously etched, thus exposing the second metal film 33.

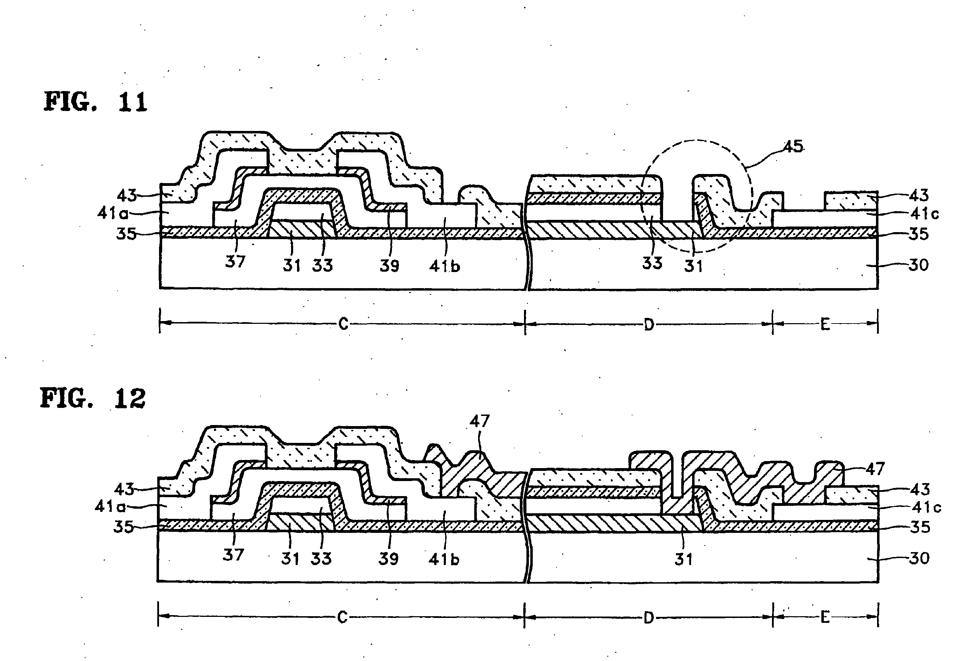

FIG. 11 shows steps of etching the exposed second metal film of the gate-pad connecting area. The first metal film 31 is exposed by etching the second metal film 33 in the gate pad connecting portion 45 and exposed by the passivation film pattern 43. The contact resistance between the pixel electrode to be formed in a subsequent process and the second metal film can be reduced by this process.

FIG. 12 shows the steps for forming a pixel electrode. A pixel electrode 47 is formed by depositing an ITO film which is a transparent conductive film on the entire surface of the substrate 30 on which the passivation film pattern is formed, and performing a fifth photolithography on the ITO film. As a result, the pixel electrode 47 and the drain electrode 41b are connected in the TFT area and the gate electrode of the gate-pad connecting area and the pad electrode 41c of the pad area are connected through the pixel electrode 47.

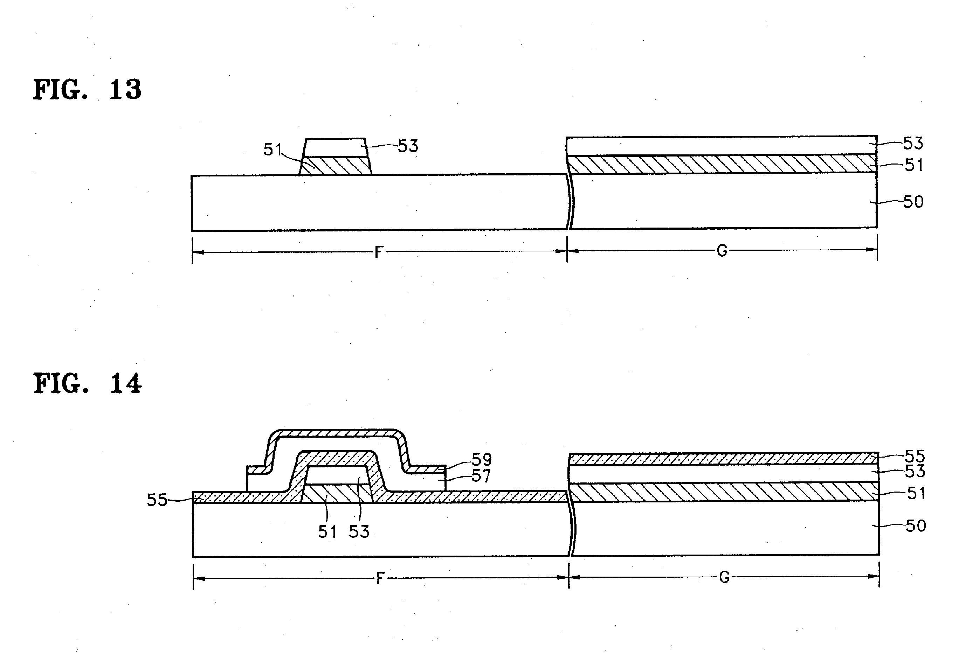

FIGS. 13 through 16 are sectional views for explaining a method for manufacturing a liquid crystal display according to a second embodiment of the present invention. Reference character F denotes a TFT area, which is a sectional view taken along the line I-I of FIG. 6 and reference character G represents a pad area, which is a sectional view taken along the line II-II of FIG. 6.

FIG. 13 shows the step for forming the gate electrode. After forming a first metal film 51 by depositing a 300^{~}4,000Å film of a refractory metal such as Cr, Ta, and Ti on the entire surface of the transparent substrate 50, a second metal film 53 is formed by depositing a 1,000^{~}4,000Å film of Al or Al alloy on the first metal film. Then, the gate electrode and the gate pad are formed in the TFT area and the pad area by performing a first photolithography on the second and the first metal films 53 and 51.

The gate electrode and the gate pad are simultaneously formed using a mask. In the first photolithography, taper etching is performed on the second metal film 53 and then on the first metal film 51. Thus, the first metal film 51 is formed to be wider than the second metal film 53.

FIG. 14 shows the step of forming a semiconductor film pattern. A semiconductor film pattern 57 to be used as an active area is formed in the TFT area by forming an insulating film 55 and the semiconductor film on the entire surface of the substrate 50 in which the gate electrode and the gate pad are formed and a second photolithography is performed on the semiconductor film. At this time, the insulating film 55 is formed to a thickness of 2,000^{~}9,000Å using a single film of a nitride film SiNₓ or a double film of a nitride film SiNₓ and an oxide film SiOₓ and the semiconductor film pattern 57 is formed by depositing the amorphous silicon and the doped amorphous silicon.

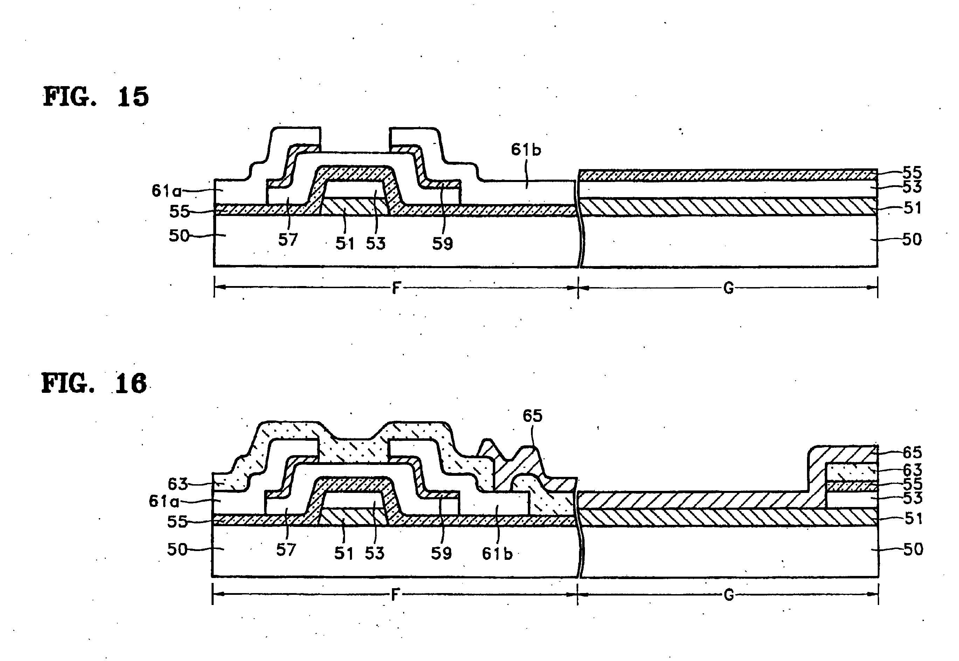

FIG. 15 shows the steps for forming a source electrode and a drain electrode. A source electrode 61a and a drain electrode 61b are formed in the TFT area by forming a third metal film by depositing a 300^{~}4,000Å thick film of a refractory metal such as Cr, Ti, and Mo on the entire surface of the substrate 50 on which the semiconductor film pattern 57 is formed and performing a third photolithography on the third metal film.

FIG. 16 shows the steps of forming a passivation film pattern and a pixel electrode. A passivation film pattern 63 is formed by forming a passivation film by depositing, for example, the nitride film on the entire surface of the substrate in which the source electrode and the drain electrode are formed and performing a fourth photolithography on the passivation film. In the fourth photolithography, a portion of the drain electrode 61b of the TFT area is exposed and the insulating film and the passivation film in the upper portion of the gate pad are simultaneously etched in the pad area, thus exposing a portion of the gate pad.

Then, the first metal film 51 is exposed by etching the portion of the second metal film 53 which is exposed by the passivation film pattern. It is possible to reduce the contact resistance between a pixel electrode to be formed in a subsequent process and the second metal film by etching the second metal film.

Then, a pixel electrode 65 which is connected to the drain electrode 61b of the TFT area and to the first metal film of the pad area is formed by depositing the ITO film.

As mentioned above, in the method for manufacturing the liquid crystal display of the present invention, it is possible to reduce manufacturing costs and to improve the manufacturing yield by using double gate electrodes, thus at least five photolithography processings are applied compared to the method of the conventional method in which at least seven photolithography processes are applied.

Also, it is possible to supress the growth of the hillock of the Al film due to the stress relaxation of the refractory metal film by forming the gate electrode of the double films of the refractory metal film and the Al film or Al alloy film formed on the refractory metal film.

Also, as shown in FIG. 16, it is possible to reduce the contact resistance between the pixel electrode to be formed a subsequent process and the Al film by etching the Al film or the Al alloy film prior to forming the pixel electrode in the pad area.

The present invention is not restricted to the above embodiments, and it is clearly understood that many variations can be possible within the scope and spirit of the present invention by anyone skilled in the art.

## Claims

1. A method for manufacturing a liquid crystal display, comprising the steps of:
forming a gate electrode and a gate pad by depositing a gate metal film over a substrate in a TFT area and a pad area;
forming an insulating film over the gate electrode and the gate pad;
forming a semiconductor film pattern over the insulating film in the TFT area;
forming a source electrode and a drain electrode in the TFT area, the source electrode and the drain electrode comprising a data metal film;
forming a passivation film pattern that exposes a portion of the drain electrode in the TFT area and a portion of the gate pad in the pad area by fomring a passivation film over the source electrode and the drain electrode; and
forming a pixel electrode that is connected to the drain electrode in the TFT area and contacts the first metal film in the pad area.

2. A method for manufacturing a liquid crystal display as recited in claim 1, the gate metal film comprises a first metal film and a second metal film over the substrate in a TFT area and a pad area.

3. A method for manufacturing a liquid crystal display as recited in claim 2, comprising the steps of: exposing the first metal film of the pad area by etching the second metal film.

4. A method for manufacturing a liquid crystal display as recited in claim 1, wherein the pixel electrode comprises a first pixel electrode pattern that is connected to the drain electrode of the TFT area and a second pixel electrode pattern that is connected to the gate pad of the pad area.

5. A method for manufacturing a liquid crystal display as recited in claim 2, wherein the pixel electrode comprises the first pixel electrode pattern that is connected to the drain electrode of the TFT area and the second pixel electrode pattern that is connected to the first metal film of the pad area.

6. A method for manufacturing a liquid crystal display as recited in claim 2, wherein the first metal film comprises a refractory metal.

7. A method for manufacturing a liquid crystal display as recited in claim 2, wherein the second metal film comprises Al or Al-alloy.

8. A method for manufacturing a liquid crystal display as recited in claim 2, wherein the first metal film comprises a material selected from the group consisting of Cr, Ta, Mo, and Ti.

9. A method for manufacturing a liquid crystal display as recited in claim 1, wherein the data metal film comprises a material selected from the group consisting of Cr, Ta, Mo, and Ti.

10. A method for manufacturing a liquid crystal display as recited in claim 2, wherein taper-etching is performed on the second metal film.

11. A method for manufacturing a liquid crystal display as recited in calim 1, wherein the insulating film comprises a nitride film.

12. A method for manufacturing a liquid crystal display as recited in claim 1, wherein the insulating film comprises a double film including a nitride film and an oxide film.

13. A TFT substrate, comprising:
a substrate;
a gate line, a gate electrode and an end portion of the gate line comprising a first metal film and a second metal film over the substrate, one of the first metal film and the second metal film comprising a refractory metal;
an insulating film over the gate electrode and having an exposed area of the refractory metal of the end portion of the gate line;
a semiconductor film pattern over the insulating film;
a data line formed over the insulating film;
a source electrode formed over a first portion of the semioconductor film;
a drain electrode formed over a second portion of the semiconductor film;
a passivation film pattern formed over the source electrode, having a contact hole over the drain electrode and having an exposed area of the refractory metal of the end portion of the gate line;
a first pixel electrode pattern electrically contacted to the drain electrode on the passivation film pattern; and
a second pixel electrode pattern electrically contacted to the exposed area of the refractory metal of the end portion of the gate line.

14. A TFT substrate, as recited in claim 13, wherein the refractory metal film comprises a material selected from the group consisting of Cr, Ta, Mo and Ti.

15. A TFT substrate, as recited in claim 13, wherein at least one of the first and the second metal films of the gate electrode and the end portion of the gate line has tapered-sidewalls.

16. A TFT substrate, as recited in claim 15, wherein the second metal film has tapered-side walls.

17. A TFT substrate as recited in claim 13, wherein a portion of said passivation pattern directly contact said semiconductor pattern.

18. A TFT substrate as recited in claim 13, wherein the data line, the source electrode and the drain electrode comprises a third metal film.

19. A TFT substrate as recited in claim 18, where the third metal film comprises a material selected from the group consisting of Cr, Ta, Mo and Ti.

20. A TFT substrate, as recited in claim 18, wherein the third metal film is electrically contacted to the second pixel electrode pattern.
